# EUROPÄISCHE PATENTSCHRIFT

(11) **EP 0 685 116 B1**
(45) Veröffentlichungstag und Bekanntmachung des Hinweises auf die Patenterteilung: **25.08.1999**
(21) Anmeldenummer: 95902059.5
(22) Anmeldetag: 08.12.1994
(51) Int. Cl.: H01L 29/866

(54) **DRIFTFREIE LAWINENDURCHBRUCHDIODE**
DRIFT-FREE AVALANCHE DIODE
DIODE A AVALANCHE SANS DERIVE

(30) Priorität: 18.12.1993 DE 4343365
(43) Veröffentlichungstag der Anmeldung: 06.12.1995
(73) Patentinhaber: ROBERT BOSCH GMBH, 70442 Stuttgart (DE)
(72) Erfinder: DAVIES, Neil, D-72820 Sonnenbühl (DE)
(86) Internationale Anmeldenummer: DE9401462
(87) Internationale Veröffentlichungsnummer: WO9517013

(56) Entgegenhaltungen:
- JAPANESE JOURNAL OF APPLIED PHYSICS, SUPPLEMENTS, Bd.43, 1974, TOKYO JA Seiten 437 - 441 Y. HAYASHI ET AL. 'Insulated gate avalanche transistor'
- PATENT ABSTRACTS OF JAPAN vol. 9, no. 240 (E-345) (1963) 26. September 1985 & JP,A,60 092 674 (ROOMU K.K.) 24. Mai 1985

## Beschreibung

### Stand der Technik

Die Erfindung geht aus von einer Diode nach der Gattung des Hauptanspruchs. Es ist schon eine Lawinendurchbruchdiode bekannt, die auf einem p-Substrat aufgebaut ist, wobei die Anode durch eine hoch p-dotierte Wanne gebildet ist, in das ein sehr hoch p-dotiertes Gebiet eingebracht ist und das hoch p-dotierte Gebiet mit einer Spannungsversorgung verbunden ist. Die Kathode wird von einem hoch dotierten n-Gebiet gebildet, das von einem hoch p-dotierten Gebiet unterlegt ist und in das p-Substrat eingebracht ist. Das hoch n-dotierte Gebiet ist mit einer positiven Spannung verbunden.

Proceedings of the 5th International Conference on Solid State Devices, Tokio 1973, Supplement to the Journal of the Japan Society of Applied Physics, Band 43, 1974, Seiten 437-441 beschreibt eine Lawinendurchbruchdiode deren Durchbruchspannung mittels eine isolierten Gateelektrode kontrollierbar ist.

### Vorteile der Erfindung

Die erfindungsgemäße Anordnung mit den Merkmalen des Anspruchs 1 hat demgegenüber den Vorteil, daß die Drift der Durchbruchspannung minimiert wird. Dieses wird erreicht, indem verhindert wird, daß der Durchbruch in der Nähe der Oberfläche des p-Substrates erfolgt. Das Verfahren zur Herstellung einer Lawinendurchbruchdiode nach Anspruch 5 hat demgegenüber den Vorteil, daß die p-dotierte Schicht und die p-dotierte Wanne automatisch zueinander justiert werden. Dabei wird der Zwischenraum zwischen der hoch dotierten p-Wanne und der hoch p-dotierten Schicht durch das Herstellungsverfahren exakt festgelegt. Dies führt zu einem kleinen Widerstand beim Durchbruch der Lawinendurchbruchdiode. Somit eignet sich diese Lawinendurchbruchdiode als genaue Spannungsreferenz.

Durch die in den Unteransprüchen aufgeführten Maßnahmen sind vorteilhafte Weiterbildungen der im Hauptanspruch angegebenen Anordnung möglich. Besonders vorteilhaft ist es, die isolierende Schicht aus Siliziumoxyd herzustellen.

Eine vorteilhafte Wahl des Materials für die leitende Schicht besteht darin, Polysilizium zu verwenden.

In vorteilhafter Weise kann diese Lawinendurchbruchdiode auch in Form einer inversen Leitfähigkeitsstruktur, d. h. anstelle von n-Material p-Material anzuordnen, hergestellt werden. Somit ist die Verwendung der Lawinendurchbruchdiode unabhängig von den verwendeten Halbleiterprozessen.

### Zeichnung

Ein Ausführungsbeispiel der Erfindung ist in der Zeichnung dargestellt und in der nachfolgenden Beschreibung näher erläutert. Es zeigt Figur 1 eine integrierte Lawinendurchbruchdiode, Figur 2 Dotierprofile, Figur 3 eine erste Ionenimplantation, Figur 4 zwei eindiffundierte Gebiete, Figur 5 eine zweite Ionenimplantation, Figur 6 ein weiteres eindiffundiertes Gebiet und Figur 7 eine dritte Implantation.

### Beschreibung des Ausführungsbeispiels

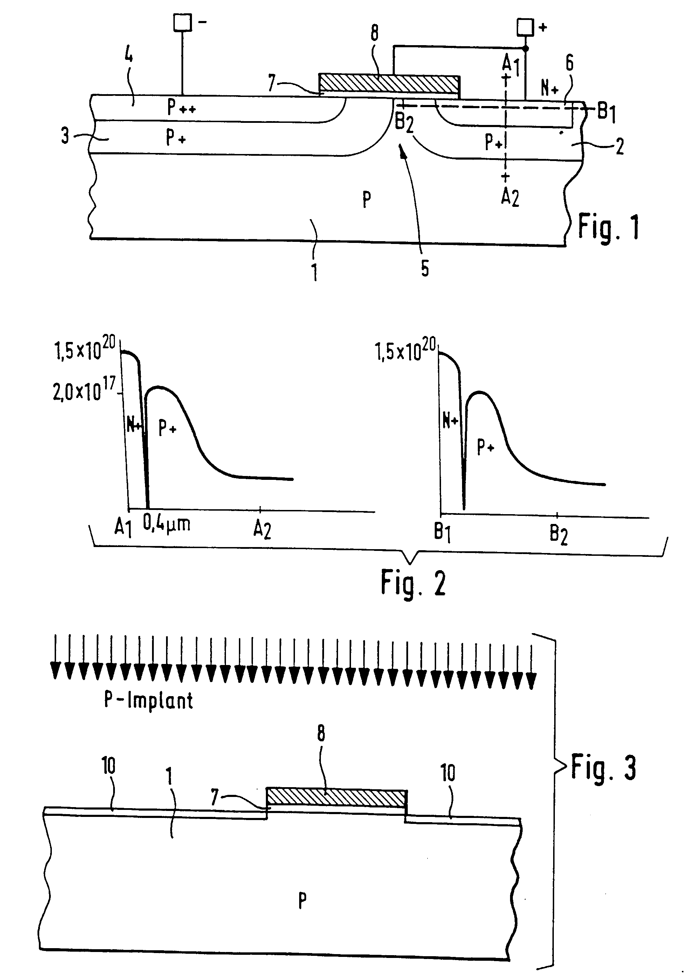

Figur 1 zeigt ein p-Substrat 1, in das eine hoch p-dotierte Wanne 3 eingebracht ist. In der Wanne 3 ist wiederum ein sehr hoch p-dotiertes erstes Gebiet 4 angeordnet. Neben der Wanne 3 ist ein hoch n-dotiertes zweites Gebiet 6 eingebracht. Das zweite Gebiet 6 ist von einer hoch p-dotierten Schicht 2 unterlegt. Die Schicht 2 und die Wanne 3 sind durch einen Zwischenraum 5 mit genau definierter Breite getrennt. Der Zwischenraum 5 wird von dem p-Substrat 1 ausgefüllt. Über dem Zwischenraum 5 ist eine isolierende Schicht 7 angeordnet. Auf der isolierenden Schicht 7 ist eine leitende Schicht 8 aufgebracht. Die leitende Schicht 8 und das zweite Gebiet 6 sind mit einem zweiten Potential, einer positiven Spannung verbunden. Das erste Gebiet 4 ist mit einem ersten Potential, einer negativen Spannung verbunden.

Für den Fachmann ist es selbstverständlich, anstelle von p-dotiertem Material n-dotiertes Material anzuordnen, d. h. die Lawinendurchbruchdiode mit Hilfe einer inversen Leitfähigkeitsstruktur aufzubauen.

In diesem Ausführungsbeispiel wurden für die Dotierung des hoch n-dotierten zweiten Gebietes 6 1,5 x 10²⁰ Ionen pro cm³ gewählt. Die Dotiertiefe liegt dabei bei 0,4 x 10⁻⁶m. Für die hoch p-dotierte Wanne 3 und die hoch p-dotierte Schicht 2 wurde eine Dotierung von 2 x 10¹⁷ Ionen pro cm³ gewählt, wobei die Dotiertiefe 1,6 x 10⁻⁶m beträgt. Das sehr hoch p-dotierte erste Gebiet 4 weist eine Dotierung von 4 x 10¹⁹Ionen pro cm³ auf, wobei die Dotiertiefe bei 0,6 x 10⁻⁶m liegt.

Die Anordnung nach Figur 1 funktioniert wie folgt: Beim Anlegen einer Durchbruchspannung an die Lawinendurchbruchdiode ist gleichzeitig die leitende Schicht 8 mit der positiven Spannung verbunden, so daß sich unter der leitenden Schicht 8 kein hohes Potential aufbaut und so ein Durchbruch in diesem Bereich verhindert wird. Der Durchbruch findet bei dieser Anordnung zwischen dem zweiten Gebiet 6 und der Schicht 2 in dem Bereich statt, in dem das zweite Gebiet 6 waagerecht auf der Schicht 2 angeordnet ist. Auf diese Weise wird erreicht, daß die Durchbruchspannung unabhängig von dem fließenden Strom und der angelegten Spannung konstant bleibt. Da der Durchbruch nicht in der Nähe einer Oberflächenschicht erzeugt wird, wird verhindert, daß Oxidladungen gebildet werden, die eine langfristige Beeinträchtigung der Funktionsweise der Lawinendurchbruchdiode erzeugen.

Figur 2 zeigt den Verlauf der Dotierprofile entsprechend den Schnittlinien A₁ - A₂ und B₁ - B₂, die in Figur 1 eingezeichnet sind, wobei die Dotierung in Ionen/cm³ gegen die Schnittlinie aufgetragen ist. Aufgrund des verwendeten Herstellungsverfahrens ist das Dotierprofil in senkrechter Richtung A₁ - A₂ dem Dotierprofil in waagerechter Richtung B₁ - B₂ sehr ähnlich. Daraus ergibt sich ein ähnliches Durchbruchverhalten in senkrechter und waagerechter Richtung. Durch Verwendung der leitenden Schicht 8 und der entsprechenden Spannungsversorgung der Schicht 8 wird in dem Zwischenraum 5 ein elektrisches Feld erzeugt, das einen Lawinendurchbruch in waagerechter Richtung B₁ - B₂ verhindert, so daß die Lawinendurchbruchdiode in senkrechter Richtung A₁ - A₂ durchbricht.

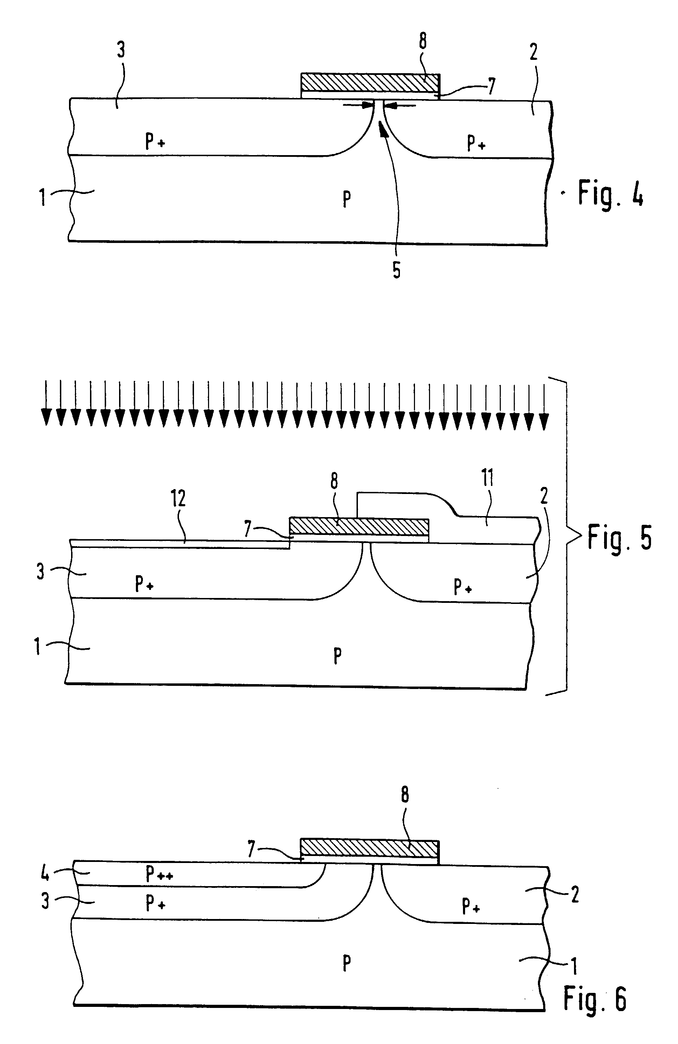

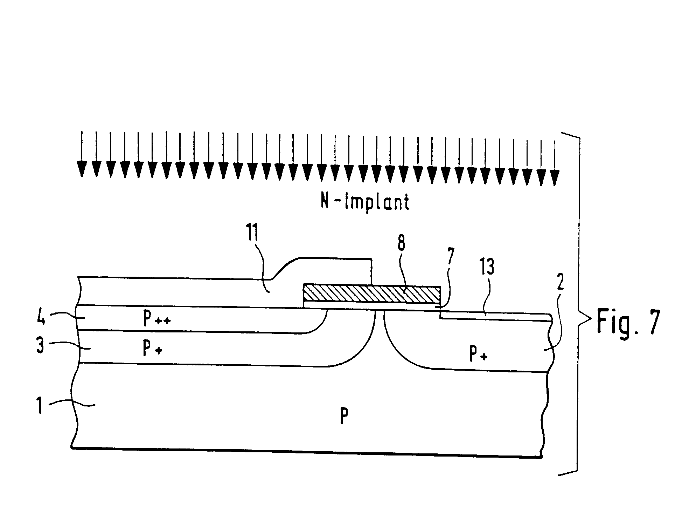

Die Lawinendurchbruchdiode wird nach einem selbstjustierenden Verfahren hergestellt. Das Verfahren wird anhand der Figuren 3 bis 7 erläutert. Zur Herstellung wird z. B. ein p-Substrat 1 verwendet, auf das eine isolierende Schicht 7 und eine Polysiliziumschicht 8 mit definierter Breite aufgebracht werden. In das p-Substrat 1 werden p-Dotier Ionen implantiert wie in Figur 3 dargestellt ist. Aufgrund der Breite der isolierenden Schicht 7 und der Polysiliziumschicht 8 werden zwei positive dotierte Oberflächenschichten 10 mit definiertem Abstand erhalten. Anschließend erfolgt eine Diffusion in der Weise, daß eine positiv dotierte Wanne 3 und eine positive Schicht 2 erhalten werden, die einen festgelegten Zwischenraum 5 mit definierter Breite unter der isolierenden Schicht 7 aufweisen, wie in Figur 4 dargestellt ist. Daraufhin wird die positiv dotierte Schicht 2 mit einem Photolack 11 abgedeckt und die Wanne 3 wird mit p-Dotier Ionen mit höherer Konzentration als bei der vorhergehenden Implantation dotiert. Somit wird eine zweite hoch positiv dotierte Oberflächenschicht 12 erhalten, wie in Figur 5 dargestellt ist. Es erfolgt eine Diffusion, so daß das positiv dotierte erste Gebiet 4 erhalten wird, wie in Figur 6 dargestellt. Daraufhin wird der Photolack 11 entfernt und das erste Gebiet 4 mit Photolack 11 abgedeckt. Nun folgt eine Implantation mit n-Dotier Ionen, so daß eine hoch negativ dotierte Oberflächenschicht 13 erzeugt wird, wie in Figur 7 dargestellt ist. Mit Hilfe einer Diffusion wird das hoch negativ dotierte zweite Gebiet 6 entsprechend Figur 1 erzeugt. Auf diese Weise wird die, in Figur 1 dargestellte, Lawinendurchbruchdiode hergestellt, wobei die Breite des Zwischenraumes 5 zwischen der Wanne 3 und der Schicht 2 genau festgelegt ist.

## Patentansprüche

1. Lawinendurchbruchdiode, die ein p-Substrat (1) aufweist, in das eine stark p-dotierte Wanne (3) eingebracht ist, wobei in die Wanne (3) ein sehr stark p-dotiertes erstes Gebiet (4) eingebracht ist, wobei neben der Wanne (3) in das p-Substrat (1) ein n-dotiertes zweites Gebiet (6) eingebracht ist und das zweite Gebiet (6) auf der Unterseite mit einer stark p-dotierten Schicht (2) unterlegt ist, wobei das erste Gebiet (4) mit einer negativen Spannung und das zweite Gebiet (6) mit einer positiven Spannung verbunden ist, dadurch gekennzeichnet, daß diese Schicht (2) das zweite Gebiet (6) in dem Bereich, der der Wanne (3) zugewandt ist, abdeckt, daß zwischen der Wanne (3) und dieser Schicht (2) ein Zwischenraum (5) definierter Breite besteht, der vom p-Substrat (1) ausgefüllt ist, daß über dem Zwischenraum (5) eine isolierende Schicht (7) angeordnet ist, daß auf der isolierenden Schicht (7) eine leitende Schicht (8) aufgebracht ist, und daß die leitende Schicht (8) mit einer positiven Spannung verbunden ist.

2. Lawinendurchbruchdiode nach Anspruch 1, dadurch gekennzeichnet, daß die isolierende Schicht (7) aus Siliziumoxyd besteht.

3. Lawinendurchbruchdiode nach einem der Ansprüche 1 oder 2, dadurch gekennzeichnet, daß die leitende Schicht (8) aus Polysilizium besteht.

4. Lawinendurchbruchdiode nach einem der vorhergehenden Ansprüche, dadurch gekennzeichnet, daß anstelle einer p-Dotierung eine n-Dotierung und anstelle der n-Dotierung eine p-Dotierung angeordnet ist, und daß das erste Gebiet (4) mit der positiven Spannung und das zweite Gebiet (6) mit der negativen Spannung verbunden ist.

5. Verfahren zur Herstellung einer Lawinendurchbruchdiode gemäß Anspruch 1, gekennzeichnet durch folgende Verfahrensschritte:
a) Aufbringen einer isolierenden Schicht (7) definierter Breite auf ein p-Substrat (1),
b) Aufbringen einer leitenden Schicht (8) auf die isolierende Schicht (7),
c) Implantation von p-Dotier Ionen in die Bereiche des p-Substrates (1), die nicht von der isolierenden Schicht (7) bedeckt sind,
d) Diffusion der implantierten p-Dotier Ionen,
e) Abdeckung des Substrates auf einer Seite (2) der isolierenden Schicht (7) mit einer Implantationsstopschicht (11), vorzugsweise Fotolack,
f) Implantation von p-Dotier Ionen mit hoher Konzentration in die Seite des Substrates (3), die nicht abgedeckt ist,
g) Diffusion der implantierten p-Dotier Ionen,
h) Entfernen der Implantationsstopschicht (11),
i) Aufbringen einer Implantationsstopschicht (11) auf die Seite des Substrates (4), in die im vorhergehenden Schritt p-Dotier Ionen implantiert wurden,
j) Implantation von n-Dotier Ionen in die nicht abgedeckte Seite des Substrates (2),
h) Entfernen der Implantationsstopschicht (11),
l) Diffusion der implantierten n-Dotier Ionen.

6. Verfahren nach Anspruch 5,
dadurch gekennzeichnet, daß anstelle des p-Substrates ein n-Substrat und anstelle der p-Dotier-Ionen n-Dotier Ionen und anstelle der n-Dotier Ionen p-Dotier Ionen verwendet werden.

## Claims

1. Avalanche breakdown diode having a p-type substrate (1) into which a heavily p-doped trough (3) is introduced, a very heavily p-doped first region (4) being introduced into the trough (3), an n-doped second region (6) being introduced into the p-type substrate (1) in addition to the trough (3), and the second region (6) being underlaid on the underside with a heavily p-doped layer (2), the first region (4) being connected to a negative voltage and the second region (6) being connected to a positive voltage, characterized in that the layer (2) covers the second region (6) in the region facing the trough (3), in that there is an interspace (5) of defined width between the trough (3) and this layer (2), which interspace is filled by the p-type substrate (1), in that an insulating layer (7) is arranged over the interspace (5), in that a conductive layer (8) is applied to the insulating layer (7), and in that the conductive layer (8) is connected to a positive voltage.

2. Avalanche breakdown diode according to Claim 1, characterized in that the insulating layer (7) consists of silicon oxide.

3. Avalanche breakdown diode according to either of Claims 1 and 2, characterized in that the conductive layer (8) consists of polysilicon.

4. Avalanche breakdown diode according to one of the preceding claims, characterized in that n-doping is arranged instead of p-doping and p-doping is arranged instead of n-doping, and in that the first region (4) is connected to the positive voltage and the second region (6) is connected to the negative voltage.

5. Process for producing an avalanche breakdown diode, according to Claim 1, characterized by the following process steps:
a) application of an insulating layer (7) of defined width to a p-type substrate (1),
b) application of a conductive layer (8) to the insulating layer (7),
c) implantation of p-doping ions into the regions of the p-type substrate (1) which are not covered by the insulating layer (7),
d) diffusion of the implanted p-doping ions,
e) covering of the substrate on one side (2) of the insulating layer (7) with an implantation barrier layer (11), preferably photoresist,
f) implantation of p-doping ions at a high concentration to that side of the substrate (3) which is not covered, g) diffusion of the implanted p-doping ions,
h) removal of the implantation barrier layer (11),
i) application of an implantation barrier layer (11) to that side of the substrate (4) into which p-doping ions were implanted in the preceding step,
j) implantation of n-doping ions into the uncovered side of the substrate (2),
k) removal of the implantation barrier layer (11),
l) diffusion of the implanted n-doping ions.

6. Process according to Claim 5, characterized in that an n-type substrate is used instead of the p-type substrate, n-doping ions are used instead of the p-doping ions and p-doping ions are used instead of the n-doping ions.

## Revendications

1. Diode à effet d'avalanche comprenant un substrat p (1) dans lequel on a réalisé une cuvette (3) à fort dopage p, et, dans la cuvette (3), on réalise un premier domaine (4) à très fort dopage p,
à côté de la cuvette (3), dans le substrat p (1), on réalise un second domaine (6) à dopage n et, sous le second domaine (6), sur la face inférieure, on réalise une couche (2) à fort dopage p,
le premier domaine (4) étant relié à la tension négative et le second domaine (6) à une tension positive,
caractérisée en ce que
- cette couche (2) recouvre le second domaine (6) dans la zone tournée vers la cuvette (3),
- entre la cuvette (3) et cette couche (2), on a un intervalle (5) de largeur définie rempli par le substrat (1) de type p,
- sur l'intervalle (5), on place une couche isolante (7),
- sur la couche isolante (7) on applique une couche conductrice (8) et,
- on relie la couche conductrice (8) à une tension positive.

2. Diode à effet d'avalanche selon la revendication 1,
caractérisée en ce que
la couche isolante (7) est en oxyde de silicium.

3. Diode à effet d'avalanche selon l'une des revendications 1 ou 2,
caractérisée en ce que
la couche isolante (8) est en polysilicium.

4. Diode à effet d'avalanche selon l'une des revendications précédentes,
caractérisée en ce qu'
à la place d'un dopage de type p, on effectue un dopage de type n et, à la place du dopage de type n, on prévoit un dopage de type p, tandis que le premier domaine (4) est mis à la tension positive et le second domaine (6) à la tension négative.

5. Procédé de fabrication d'une diode à effet d'avalanche selon la revendication 1,
caractérisé par les étapes suivantes :
a) on applique une couche isolante (7) de largeur définie sur un substrat (1) de type p,
b) on applique une couche conductrice (8) sur la couche isolante (7),
c) on implante des ions de dopage p dans les domaines du substrat (1) de type p qui ne sont pas recouverts par la couche isolante (7),
d) on diffuse les ions d'implantation de dopage p,
e) on recouvre le substrat sur un côté (2) de la couche isolante (7), par une couche d'arrêt d'implantation, de préférence un vernis photosensible,
f) on implante des ions de dopage p avec une forte concentration dans le côté du substrat (3) non recouvert,
g) on diffuse les ions implantés de dopage p,
h) on enlève la couche d'arrêt d'implantation (11),
i) on applique une couche d'arrêt d'implantation (11) sur le côté du substrat (4) dans lequel on a implanté des ions de dopage p au cours de l'étape précédente,
j) on implante des ions de dopage n dans le côté recouvert du substrat (2),
h) on enlève la couche d'arrêt d'implantation (11),
l) on diffuse les ions implantés de dopage n.

6. Procédé selon la revendication 5,
caractérisé en ce qu'
à la place du substrat p, on utilise un substrat de type n, à la place des ions de dopage p, on utilise des ions de dopage n et, à la place des ions de dopage n, on utilise des ions de dopage p.
